Europäisches Patentamt

European Patent Office

Office européen des brevets

(11) Numéro de publication: **0 387 955**
**A1**

## (12) DEMANDE DE BREVET EUROPEEN

(21) Numéro de dépôt: 90200566.9

(22) Date de dépôt: 12.03.90

(51) Int. Cl.5: **H01L 23/66**

(30) Priorité: 17.03.89 FR 8903522

(43) Date de publication de la demande:
19.09.90 Bulletin 90/38

(84) Etats contractants désignés:
**DE FR GB IT**

(71) Demandeur: **LABORATOIRES
D'ELECTRONIQUE PHILIPS
3, Avenue Descartes
F-94450 Limeil-Brévannes(FR)**

(84) **FR**

Demandeur: **N.V. Philips'
Gloeilampenfabrieken
Groenewoudseweg 1**

**NL-5621 BA Eindhoven(NL)**

(84) **DE GB IT**

(72) Inventeur: **Gamand, Patrice, Société Civile
S.P.I.D.
209, rue de l'Université
F-75007 Paris(FR)**
Inventeur: **Meunier, Jean-Christophe, Société
Civile S.P.I.D.
209, rue de l'Université
F-75007 Paris(FR)**

(74) Mandataire: **Landousy, Christian et al
Société Civile S.P.I.D. 156, Boulevard
Haussmann
F-75008 Paris(FR)**

(54) **Boîtier pour circuit intégré hyperfréquences.**

(57) Boîtier pour circuit intégré hyperfréquences (50) comprenant un socle (1) muni d'un évidement (10) dont le fond est métallisé et de connecteurs périphériques (2,3) , et comprenant un dispositif de connexion inséré dans l'évidement entre le circuit intégré et les connecteurs, ce dispositif de connexion incluant un substrat qui présente une face supérieure munie de lignes microrubans (14,15,16,17) pour relier des plots (20, 30) du circuit intégré aux connecteurs du socle et une face inférieure métallisée pour former un plan de masse (12), caractérisé en ce que le socle comprend deux parties assemblées, la première partie (1') dite périphérique portant les connecteurs (2,3), une première région du dispositif de connexion (4,4',6,6') et un logement (11) pratiqué dans l'évidement (10), logement dont les dimensions sont indépendantes de celles du circuit intégré (50) à protéger, et qui est approprié à recevoir au plus juste la seconde partie (1") dite centrale, cette dernière portant le circuit intégré (50) et une seconde région (5,5') du dispositif de connexion dite complémentaire, dont les dimensions sont dépendantes de celles du circuit intégré à protéger, pour approcher ce dernier au plus près, de manière telle que la longueur des fils de connexion (13) entre les lignes microrubans (15,16) et les plots (80,30) du circuit intégré est minimale.
Application: Protection des circuits intégrés hyperfréquences dans le domaine 30 à 60 GHz et plus.

FIG.3

# BOITIER POUR CIRCUIT INTEGRE HYPERFREQUENCES

L'invention concerne un boîtier incluant un socle muni d'un évidement, dont le fond est métallisé, et muni de connecteurs disposés à la périphérie de l'évidement, et comprenant un dispositif de connexion inséré dans l'évidement entre le circuit intégré et les connecteurs, ce dispositif de connexion incluant un substrat qui présente une face supérieure munie de lignes microrubans pour relier des plots du circuit intégré aux connecteurs du socle et une face inférieure métallisée pour former un plan de masse.

L'invention trouve son application dans le domaine des circuits intégrés hyperfréquences où la fréquence des signaux est dans la fourchette des 30 à 60 GHz.

A ce jour, les circuits intégrés fonctionnant à des fréquences aussi élevées commencent à voir un développement important. Ils ne peuvent être commercialisés que munis d'un boîtier approprié à ne pas faire baisser leurs performances. Or, précisément, les progrès technologiques en matière de circuits intégrés hyperfréquences ont été plus rapides dans les centres de recherche que dans les centres de développement industriels, si bien qu'il n'existe pas encore de boîtiers capables de recevoir de tels circuits intégrés pour les commercialiser avec les performances indispensables.

A cet effet, il est bon de rappeler qu'on ne peut utiliser des boîtiers déjà existants pour circuits hyperfréquences dans le domaine de 1 à 6 GHz, ou bien des boîtiers pour circuits intégrés numériques, ni les transposer purement et simplement afin de les utiliser dans un domaine où la fréquence est de l'ordre de 10 fois supérieure. Car les problèmes techniques qui se posent aux fréquences du domaine 30-60 GHz sont extrêmement spécifiques.

Ainsi, on connaît par la demande de brevet EP 88202608.1 un boîtier pour circuits intégrés numériques. Ce boîtier comprend un socle, muni d'un évidement, pour recevoir le circuit intégré et des plots de contact disposés sur le socle à la périphérie de l'évidement. Ce boîtier comprend en outre un dispositif de connexion inséré dans l'évidement du socle. Ce dispositif de connexion est constitué d'un substrat formé d'une plaquette d'alumine, elle-même munie d'un évidement central pour le circuit intégré, et qui porte sur sa face supérieure, outre des lignes microrubans d'impédance 50 Ω,des résistances et des capacités, disposées radialement, s'étendant du bord de l'ouverture centrale proche du circuit intégré à la périphérie proche de l'évidement du socle. Ce dispositif de connexion est encore muni d'un plan de masse disposé sur sa face inférieure, pour faire contact avec un plan de masse disposé sur le fond de l'évidement du boîtier.

Pour connecter un plot de masse du circuit intégré au plan de masse du boîtier, une ligne de masse contourne la plaquette substrat par la tranche, ce qui fait que, pour ce raccordement, la distance est très longue.

Ceci limite l'utilisation d'un tel système à un domaine de fréquences inférieur d'un ordre de grandeur au domaine de fréquences recherché pour la présente application de l'invention.

D'autre part, une fois le circuit intégré et le dispositif de connexion en place, chaque ligne microruban d'impédance 50 Ω est reliée par un fil court à un plot du socle, lequel se continue par un ruban métallique imprimé sur le socle et qui contourne ce socle par la tranche pour aller jusqu'à sa face inférieure. Ce ruban qui constitue le moyen de connexion avec les circuits extérieurs au boîtier, est alors un simple conducteur et non pas un connecteur d'impédance donnée telle que 50 Ω. Le boîtier est dit du type sans broches.

Ceci limite aussi l'utilisation d'un tel boîtier aux circuits intégrés basses fréquences ou aux circuits numériques, et ne permet pas d'atteindre les fréquences élevées recherchées pour les présentes applications.

De plus, le socle de ce boîtier est en résine ce qui ne permet pas de réaliser le blindage nécessaire pour le fonctionnement aux fréquences requises. Enfin, dans le document cité, il n'est rien dit des questions d'étanchéité, ni des questions de dissipations thermiques.

Les problèmes techniques posés par la réalisation de boîtiers pour des circuits intégrés fonctionnant à des fréquences aussi élevées que 30-60 GHz ou plus, sont les suivants :

- Ce boîtier doit présenter au moins une ligne d'impédance donnée par exemple 50 Ω reliant une entrée ou une sortie hyperfréquences du circuit intégré à un connecteur d'impédance correspondante de type coaxial, cette connexion étant réellement une ligne hyperféquences sur toute sa longueur ;

- Ce boîtier doit donc présenter à sa périphérie au moins un tel connecteur coaxial pour établir cette connexion ;

- Ce boîtier doit présenter aussi des connecteurs standards disposés à sa périphérie et des lignes pour relier ces connecteurs aux plots d'alimentation continue du circuit intégré ;

- Ce boîtier doit présenter un plan de masse sans discontinuités ;

- Ce boîtier doit constituer un blindage, être étanche, pouvoir supporter des températures de -40 à +125°C ;
- Ce boîtier doit en outre être aisé à fabriquer et d'un coût modique.

A cet effet, il doit pouvoir recevoir des circuits intégrés de toutes dimensions sans modifications substantielles de sa structure.

Selon la présente invention, ces problèmes sont résolus au moyen d'un boîtier tel que décrit dans le préambule et en outre caractérisé en ce que le socle comprend deux parties assemblées, la première partie dite périphérique portant les connecteurs, une première région du dispositif de connexion et un logement pratiqué dans l'évidement, logement dont les dimensions sont indépendantes de celles du circuit intégré à protéger, et qui est approprié à recevoir au plus juste la seconde partie dite centrale du socle, cette dernière portant le circuit intégré et une seconde région du dispositif de connexion dite complémentaire, dont les dimensions sont dépendantes de celles du circuit intégré à protéger, pour approcher ce dernier au plus près, de manière telle que la longueur des fils de connexion entre les lignes microrubans et les plots du circuit intégré est minimale.

L'avantage procuré par ce boîtier est que la première partie du socle peut être fabriquée en très grande série, donc avec un coût modique, car elle ne dépend pas du circuit intégré particulier à protéger, alors que la partie centrale est fabriquée en séries plus petites, chaque série étant adaptée notamment aux dimensions du circuit intégré particulier à protéger. Mais cette partie centrale consiste en une partie de socle de forme particulièrement simple dans laquelle seule une caractéristique change pour l'admission de chaque circuit intégré particulier.

On obtient ainsi un bon compromis entre l'abaissement du coût de fabrication et l'excellence de la qualité qui est requise pour l'exploitation des circuits intégrés hyperfréquences, du fait que les fils de connexion entre lignes microrubans et plots sont toujours de longueur minimale, quel que soit le circuit abrité par le boîtier.

Dans une mise en oeuvre de l'invention, ce boîtier est en outre caractérisé en ce que la première et la seconde partie du socle comprennent des moyens d'assemblage pour reconstituer un plan de masse continu sous l'ensemble des première et seconde régions du dispositif de connexion, de manière à éviter la formation de discontinuités constituant des cavités résonantes en hyperfréquences.

Un avantage présenté par ce boîtier, est alors que le plan de masse du dispositif de connexion est absolument continu et que les phénomènes de résonances qui auraient pu se produire du fait de la réalisation du socle en deux parties, lors de l'assemblage de ces deux parties, sont soigneusement évités.

Dans une mise en oeuvre particulière de l'invention, ce boîtier est caractérisé en ce que les moyens d'assemblage incluent :
- d'une part la disposition de la première région du dispositif de connexion en retrait par rapport au bord du logement, ainsi qu'une couche métallique interposée entre le plan de masse de cette première région et le fond de l'évidement métallisé, cette couche métallique étant en biseau entre le bord de la première région et le bord du logement ;
- d'autre part la disposition de la région complémentaire du dispositif de connexion en surplomb par rapport au bord de la partie centrale du socle, ce surplomb étant d'une grandeur sensiblement égale à la dimension du retrait de la première partie, ainsi qu'une couche métallique de même épaisseur que précédemment, interposée entre le plan de masse de la région dite complémentaire du dispositif de connexion et le fond de l'évidement métallisé, cette couche métallique étant en biseau entre le bord de ladite région complémentaire et le bord de ladite partie centrale du socle ;
en ce que ces moyens incluent encore le fait que ces couches métalliques ainsi interposées constituent un scellement desdites régions du dispositif de connexion sur leur partie de socle respective dans lesdites positions, et en ce que ces moyens incluent aussi le contact des deux parties du socle par les surfaces disposées l'une sur l'autre des plages biselées de pente complémentaire desdites couches métalliques, ainsi que l'assujettissement des deux parties du socle entre elles pour maintenir la continuité du plan de masse formé par lesdites couches métalliques.

L'avantage procuré par cette mise en oeuvre, est que l'assemblage des deux parties du socle est simple, et le bon contact des deux parties de plan de masse nécessaire à éviter les discontinuités engendrant des résonances, est particulièrement efficace.

Dans une mise en oeuvre particulière, ce boîtier est caractérisé en ce que l'assujettissement des deux parties du socle est fait par au moins une vis unissant le fond du logement pratiqué dans la première partie du socle, à la partie centrale du socle disposée dans ce logement.

L'avantage procuré par cette fixation est qu'elle est très simple et peu coûteuse, et le contact électrique d'un plan de masse à l'autre est parfait.

Dans une mise en oeuvre particulière, ce boîtier est caractérisé en ce que la tête de vis est enrobée d'une résine jointive avec le fond du socle.

L'avantage est alors que le socle est étanche.

Dans une mise en oeuvre particulière, ce boîtier est caractérisé en ce qu'il est métallique.

L'avantage en est qu'il permet des performances maintenues entre -40°C et +125°C et une très bonne dissipation thermique.

Dans une variante de cette dernière mise en oeuvre ce boîtier est caractérisé en ce qu'il est formé d'un matériau plastique métallisé.

L'avantage particulier procuré par cette variante, est que le boîtier est d'un coût réduit.

Dans l'une et l'autre de ces mises en oeuvre, le blindage hyperfréquences du circuit est obtenu.

Dans une mise en oeuvre préférentielle, le substrat du dispositif de connexion est en alumine (Al₂O₃) dont la face inférieure porte un plan de masse, par exemple réalisé au moyen d'une couche d'or, et en ce que la couche métallique qui est interposée entre les parties du dispositif de connexion et leurs parties de socle respectives est une couche d'alliage InPb qui effectue aussi le scellement entre les parties respectives et assure la continuité du plan de masse par le contact de ses plages biselées de pente complémentaire.

Dans ces conditions, ce scellement supporte les températures de -40° à +125° C, et d'autre part le plan de masse est en contact électrique avec le blindage du boîtier.

Dans une mise en oeuvre, ce boîtier est caractérisé en ce que les connecteurs périphériques comprennent au moins un connecteur hyperfréquences de type coaxial et d'impédance déterminée, et en ce que le dispositif de connexion comprend au moins une ligne microruban de même impédance, joignant un plot du circuit intégré audit connecteur.

L'avantage procuré est alors que la ligne hyperfréquence constituée est de l'impédance voulue sur toute sa longueur. Il n'existe pas, comme dans le dispositif cité au titre d'état de la technique, des connecteurs pour lignes microrubans hyperfréquences qui ne soient pas eux-mêmes des connecteurs hyperfréquences de l'impédance voulue.

Dans une réalisation particulière, ce boîtier est caractérisé en ce que, pour obtenir des lignes hyperfréquences d'impédance donnée, le substrat du dispositif de connexion présente une épaisseur fonction de la largeur de ligne microruban et de la fréquence de fonctionnement du circuit intégré, la ligne hyperfréquences étant constituée des trois couches superposées du plan de masse, du matériau du substrat et du ruban métallique disposé en surface de ce substrat.

L'avantage est que, en agissant sur l'épaisseur du substrat, on peut non seulement obtenir des lignes hyperfréquences d'impédance voulue, mais ceci à des fréquences très élevées, supérieures à 40GHz.

Dans une réalisation particulière, ce boîtier est caractérisé en ce qu'il comprend un nombre de 1 à 4 connecteurs coaxiaux hyperfréquences d'impédance 50 Ω et un nombre correspondant de lignes microrubans de même impédance, pour relier des plots du circuit intégré auxdits connecteurs, les lignes hyperfréquences étant en outre disposées les unes par rapport aux autres de manière à éviter les couplages parasites.

Cette forme de réalisation présente l'avantage d'être capable d'admettre la plus grande partie des types connus de circuits hyperfréquences : amplificateurs, oscillateurs, mélangeurs, déphaseurs et ensembles plus complexes combinant les circuits précédents.

Dans une réalisation particulière, ce boîtier est caractérisé en ce qu'il comprend un ou plusieurs connecteurs et un nombre correspondant de rubans conducteurs en surface du dispositif de connexion, pour relier des plots du circuit intégré à des alimentations continues.

Dans une réalisation préférentielle, ce boîtier est caractérisé en ce que, ces connecteurs pour alimentation continue sont du type coaxial et sont disposés à la périphérie dudit boîtier dans des régions éloignées des connecteurs hyperfréquences.

Dans une telle réalisation, le boîtier peut être rectangulaire, les connecteurs hyperfréquences étant sur des côtés parallèles et les connecteurs continus sur les autres côtés parallèles.

Dans ces conditions, les alimentations continues ne perturbent pas les signaux hyperfréquences qui présentent parfois une amplitude notablement moins forte.

Dans une réalisation particulière, ce boîtier est caractérisé en ce que des capacités de découplage en continu sont connectées entre les connecteurs pour tension continue et les rubans conducteurs respectifs pour alimentation continue.

Dans ces conditions, le boîtier permet le découplage en continu des alimentations.

Dans une réalisation préférentielle, les connecteurs coaxiaux sont constituées par une âme isolée du boîtier métallique ou métallisé par une perle de verre scellée au boîtier, par exemple par un alliage InPb.

Un tel scellement est non seulement étanche mais supporte les températures déjà indiquées.

Dans une telle réalisation, les capacités de découplage seront de préférence formée de la succession d'une première couche métallique, une couche diélectrique et une seconde couche métallique, la première couche métallique étant fixée sur le boîtier métallique ou métallisé formant masse, et la seconde couche métallique étant reliée par des fils courts et fins aux extrémités les plus proches de lignes conductrices pour alimentations continue.

Une telle réalisation présente l'avantage de permettre l'emploi de capacités de découplage standards commercialisées de valeurs plus grandes et plus appropriées à l'application envisagée que si elles étaient réalisées sur le dispositif de connexion selon le procédé connu de l'état de la technique cité.

Dans une réalisation, la partie centrale du socle portant le circuit intégré à sa surface est muni d'un MESA pour recevoir ce circuit intégré, de dimension transversale identique à celle du circuit intégré, de manière telle que la surface supérieure du circuit intégré est au même niveau que la surface supérieure du dispositif de connexion, pour permettre la liaison entre les extrémités des lignes micro-rubans et conducteurs micro-rubans, et les plots correspondants du circuit intégré au moyen de fils fins extrêmement courts.

Dans cette réalisation, les liaisons diverses sont particulièrement optimisées. C'est la dimension transversale de ce MESA qui change d'un circuit intégré à un autre et parfois son épaisseur. Il est clair que cet ajustage n'apporte pas un coût supplémentaire conséquent lors de la réalisation de la partie centrale du socle.

Dans une forme de réalisation, ce boîtier est caractérisé en ce qu'il est muni d'un couvercle fixé au socle de façon étanche.

L'invention sera mieux comprise au moyen de la description suivante illustrée par les figures annexées dont :

- la figure 1a qui représente schématiquement le socle du boîtier selon l'invention en coupe selon l'axe XX$'$ de la figure 2a ;

- la figure 1b qui représente schématiquement le socle du boîtier selon l'invention en coupe selon l'axe YY$'$ de la figure 2a ;

- la figure 2a qui représente schématiquement le boîtier selon l'invention vu du dessus dans le cas où il présente 2 connecteurs hyperfréquences et la figure 2b dans le cas où il présente 4 connecteurs hyperfréquences ;

- la figure 3 qui représente schématiquement en coupe la partie centrale du socle grossie pour montrer les moyens d'assemblage des deux parties du socle.

- la figure 4 qui représente les coefficients $S_{11}$ et $S_{21}$.

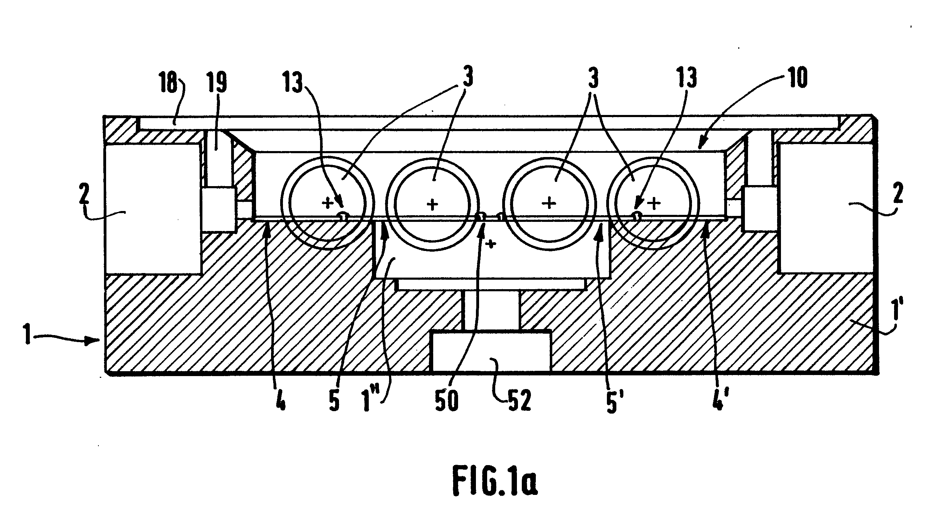

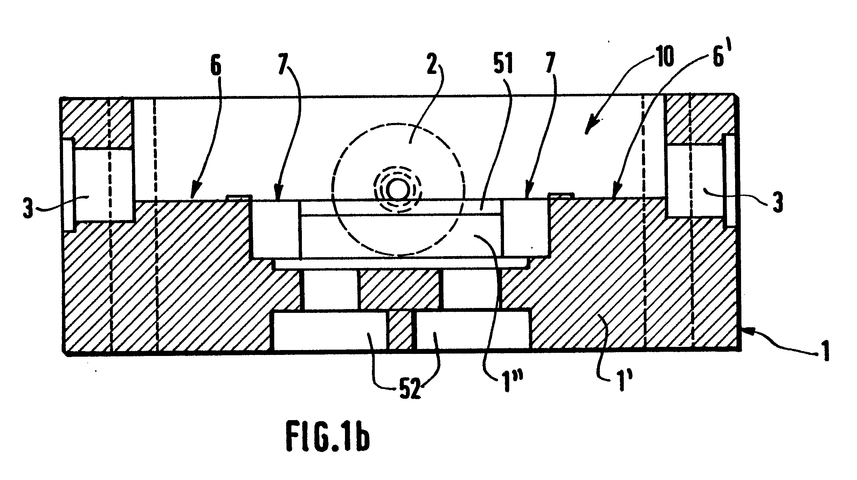

Tel que représenté sur les figures 1 schématiquement en coupe, le boîtier pour circuit hyperfréquences selon l'invention présente d'abord un socle 1 muni d'un évidement 10, et autour de l'évidement, des connecteurs périphériques 2 et 3.

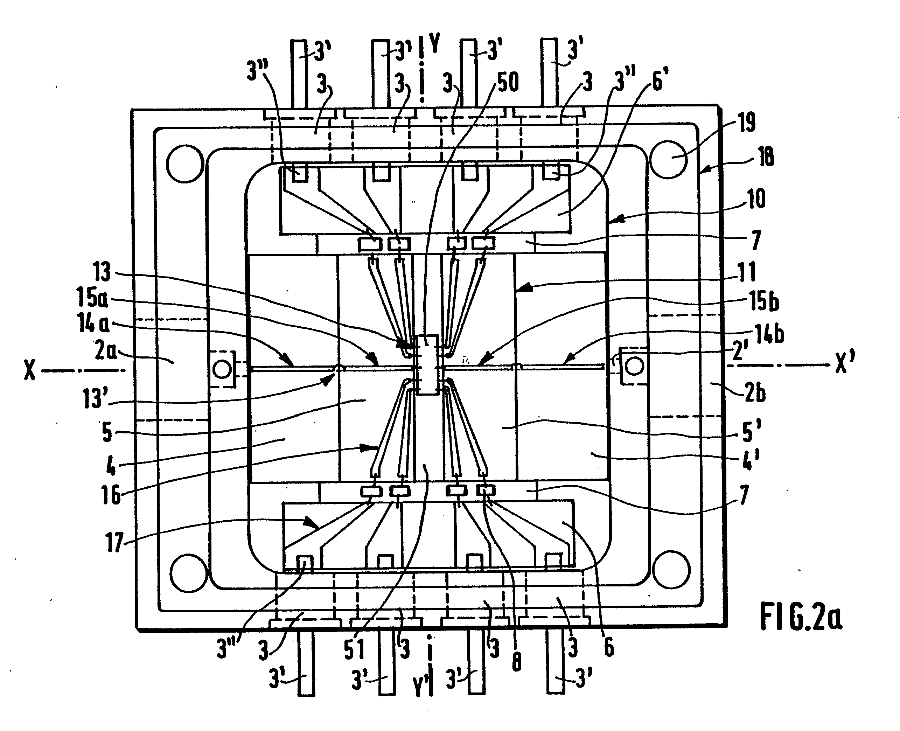

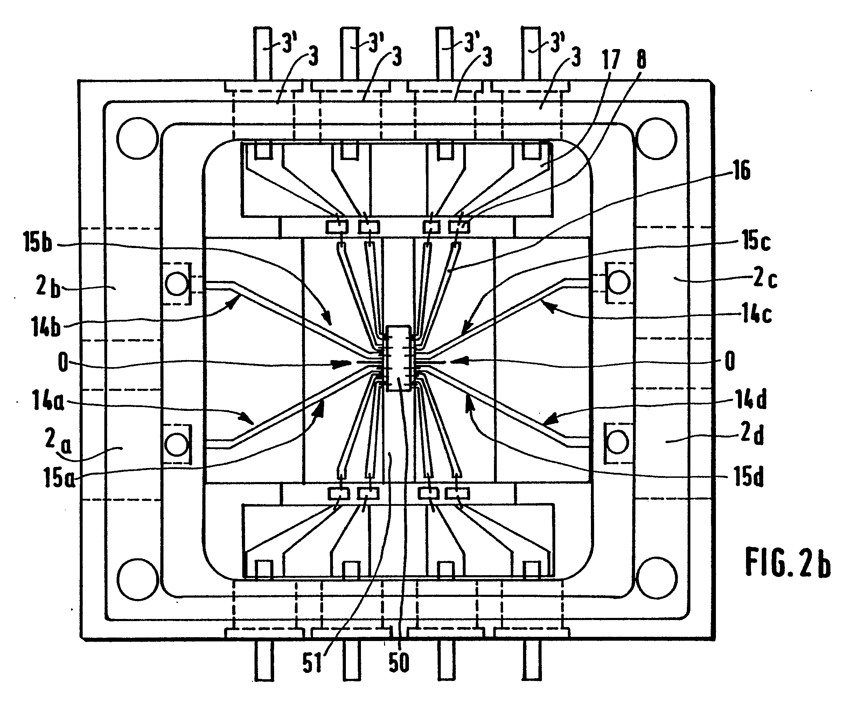

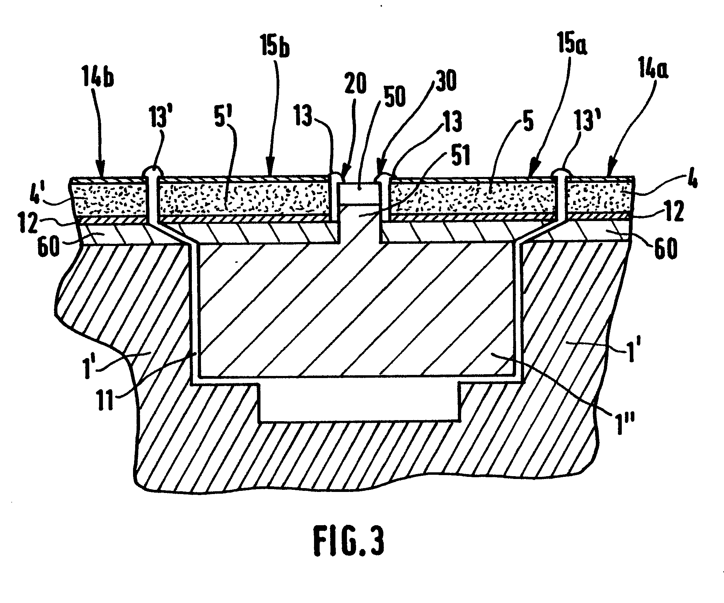

Les figures 2a et 2b montrent, vu du dessus qu'un circuit intégré hyperfréquences 50 est disposé au centre de l'évidement et que ses différents plots d'entrée/sortie 20/30 (voir la figure 3) sont reliés aux connecteurs périphériques 2/3 du boîtier par un dispositif de connexion. Ce dispositif de connexion comprend au moins un substrat formé des parties 4, 4$'$, 5 , 5$'$ et 6, 6$'$ en un matériau diélectrique ou semi-isolant, qui inclut des lignes micro-rubans réalisées sur sa face supérieure et un plan de masse 12 réalisé sur sa face inférieure (voir la figure 3). Le matériau du substrat peut être en alumine ($Al_2O_3$) s'il est choisi diélectrique, en un composé III/V s'il est choisi semi-isolant, ou encore en silicium. Il peut être aussi en tout matériau diélectrique ou semi-isolant ou semiconducteur compatible avec les hyperfréquences.

Les connecteurs périphériques sont de deux sortes. On trouve d'une part des connecteurs hyperfréquences 2, et d'autre part des connecteurs pour amener les tensions continues d'alimentation 3. Les connecteurs hyperfréquences sont du type coaxial d'impédance déterminée, et reliés au plot du circuit intégré 50 par des lignes hyperfréquences 14, 15 de même impédance. A cet effet, les lignes hyperfréquences sont constituées par des rubans métalliques réalisés en surface du dispositif de connexion et dont la largeur est fonction du matériau du substrat, de son épaisseur et de la fréquence f de fonctionnement du circuit intégré. Des fils courts et fins 13 raccordent ensuite les extrémités des rubans métalliques aux plots hyperfréquences du circuit intégré. D'autre part l'âme 2$'$ des connecteurs coaxiaux s'appuie sur l'autre extrémité de ces rubans métalliques pour réaliser la liaison hyperfréquences.

Dans le but d'atteindre de très hautes fréquences (30 à 100 GHz), ces fils 13 doivent être aussi courts et fins que possible. Le dispositif de connection réalisé sur le substrat 4, 4$'$, 5, 5$'$, 6 et 6$'$ doit donc être disposé au plus près autour du circuit intégré 50.

D'autre part le boîtier selon l'invention est prévu pour abriter les circuits intégrés de toute sorte, tels que mélangeurs, oscillateurs fonctions électriques, ou amplificateurs, qui présentent des dimensions différentes.

Or, pour préserver les performances d'un circuit intégré fonctionnant à des fréquences aussi hautes que 30 à 100 GHz, le boîtier doit être lui-même très performant, donc coûteux. Il est alors intéressant de pouvoir le fabriquer en série aussi grande que possible. Ceci est en contradiction avec le fait qu'il doit être spécifique de chaque circuit, car cela conduit à des fabrications plus petites.

Selon l'invention, un compromis à été trouvé en fabriquant le socle en deux parties. Une première partie est munie des caractéristiques universelles pouvant être utilisée pour tous types de circuit intégré et, fabriquée en grande série. Et une seconde partie est adaptée au mieux à chaque circuit intégré et est fabriquée en série plus petite spécifique de ces circuits intégrés, mais permettant d'en conserver les très hautes performances.

En effet, et comme montré d'une part vu du dessus sur les figures 2a et 2b, et d'autre part en coupe sur les figures 1a, 1b et 3, le socle comprend une première partie 1′ dite périphérique et une seconde partie 1″ dite centrale.

La partie périphérique 1′ du socle porte :
- les connecteurs hyperfréquences 2 qui peuvent être par exemple au nombre de 1 à 4 (dans ces cas référencés 2a, 2b, 2c, 2d (voir les figures 2a et 2b vu du dessus) ;
- les connecteurs 3 pour alimentations continues qui peuvent être par exemple au nombre de 8 (voir les figures 2a et 2b vu du dessus qui sont disposés de façon à être éloignés des connecteurs hyperfréquences, et qui sont aussi de préférence des connecteurs coaxiaux ;
- desdites premières régions de dispositif de connexion disposées à la périphérie de l'évidement 10. On trouve d'une part les régions 4 et 4′ qui portent des tronçons de lignes hyperfréquences 14 (éventuellement 14a, 14b, 14c, 14d selon le nombre des connecteurs hyperfréquences). Les régions 4 et 4′ sont disposées au plus près des connecteurs hyperfréquences pour que la liaison entre les extrémités des lignes hyperfréquences 14 et l'âme des connecteurs coaxiaux hyperfréquences 2 puisse être faite comme on l'a dit par contact. On trouve d'autre part les régions 6 et 6′ qui portent les tronçons de lignes 17, qui peuvent être au nombre de 8 selon le nombre de connecteurs 3 pour le continu. Les régions 6 et 6′ sont disposées de telle sorte que l'âme 3′ des connecteurs 3 vienne à proximité des tronçons de ligne 17, pour que la liaison entre l'âme 3′ desdits connecteurs et l'extrémité des lignes 17 se fasse également par contact.

La partie périphérique 1′ du socle comprend encore un logement 11 disposé au centre de l'évidement 10 et de manière à être entouré par lesdites premières régions 4, 4′, 6 et 6′ du dispositif de connexion.

Ce logement 11 présente des dimensions indépendantes de celles du circuit intégré 50 à protéger. Il est approprié à recevoir au plus juste la seconde partie 1″ dite partie centrale du socle.

Cette partie 1″ du socle porte :
- le circuit intégré 50 disposé de préférence sur un MESA 51 de manière à pouvoir être exactement de niveau avec les différentes parties du dispositif de connexion. Ce MESA 51 est constitué par un simple ruban en relief à la surface de la partie centrale 1″ du socle et est très aisé à fabriquer. Il est mis en oeuvre de manière à présenter exactement la même dimension transversale que le circuit intégré 50 à protéger. C'est sa mise en oeuvre qui fait que la partie centrale du socle est spécifique de chaque circuit intégré.
- desdites secondes régions 5 et 5′ du dispositif de connexion disposées de part et d'autre du MESA 51 et au plus près de celui-ci. Ces régions 5 et 5′ portent des tronçons de lignes hyperfréquences 15 disposés de manière à assurer la continuité avec les tronçons de ligne 14 entre les connecteurs 2 et les plots d'entrée/sortie 20 hyperfréquences du circuit intégré (voir la figure 3). Lesdites secondes régions 5 et 5′ portent aussi des lignes 16 disposées de manière à assurer la continuité avec les tronçons de ligne d'alimentation continue 17 entre les connecteurs 3 et les plots d'alimentation continue 30 du circuit intégré.

Cependant, selon l'invention, les deux parties du socle 1′ et 1″ sont munies de moyens d'assemblage perfectionnés. En effet, les lignes hyperfréquences étant constituées comme on l'a dit précédemment des trois couches de ruban 14, 15, du substrat 4, 4′, 5, 5′ et du plan de masse 12, s'il apparaît un discontinuité dans le plan de masse, par exemple si le contact électrique entre les différentes parties du plan de masse est simplement fait par le contact de la première partie du socle 1′ et de la seconde partie de socle 1″, l'intervalle 11′ entre ces deux parties du socle forme une cavité résonnante qui perturbe le signal hyperfréquences. En conséquence ces moyens d'assemblage doivent permettre de reconstituer un plan de masse continu sous l'ensemble des première et seconde régions du dispositif de connexion de manière à éviter la formation d'une telle discontinuité constituant une cavité résonnante en hyperfréquences.

Selon l'invention ce problème peut être résolu par la mise en oeuvre des moyens d'assemblage des deux parties du socle selon le système suivant :
- tout d'abord on dispose la première région 4, 4′ du dispositif de connexion en retrait par rapport au bord du logement 11. Une couche métallique 60 est alors formée entre le plan de masse 12 du dispositif de connexion 4, 4′ et le fond de l'évidement 10. Le fond de cet évidement 10 est soit métallique, soit métallisé. On choisit la couche métallique 60 parmi les alliages aptes à former le scellement entre le plan de masse 12 et le fond métallisé de l'évidement 10. Lors du scellement, on forme une plage biselée entre le bord des parties 4 et 4′ du dispositif de connexion et le bord correspondant du socle 1′ (voir figure 3),
- puis on dispose ladite seconde région 5, 5′ du dispositif de connexion en surplomb de la partie centrale 1″ du socle. On réalise ce surplomb d'une dimension sensiblement égale au retrait de la première région 4, 4′. Une couche métallique 60 est formée de la même manière que précédemment entre le dispositif de connexion 5, 5′ et la surface de la partie du socle 1″ qui est au niveau du fond de l'évidement 10 déjà décrit et est métallisée ou métallique comme ci-dessus. On forme le scellement du plan de masse 12 des parties 5, 5′ avec cette surface, et ce faisant on forme une plage biselée entre le bord des parties 5 et 5′ du dispositif de connexion et le bord de la partie centrale du socle 1″. Comme le montre la figure 3 les pentes des plages biselées sont complémentaires. Chacune des régions 4, 4′, 5, ·5′ du dispositif de connexion est scellée sur la partie du socle respective dans lesdites positions. Et la partie centrale du socle 1″ est introduite dans le logement 11 de telle manière que les plages biselées de pentes complémentaires des couches 60 respectivement des première et seconde parties du dispositif de connexion soient mises en contact. Puis la partie 1″ est assujettie à la partie du socle 1′ par exemple au moyen d'une vis 52, ou de plusieurs vis si nécessaire.

Dans ces conditions, le plan de masse de l'ensemble du dispositif de connexion est reconstitué et de présente pas de discontinuité.

La cavité 11′ qui se forme entre la partie du socle 1′ périphérique et la partie centrale du socle 1″ n'a alors pas d'influence sur le signal hyperfréquence. Les parties 5 et 5′ du dispositif de connexion et 4 et 4′ du dispositif de connexion étant prévues de dimensions telles que l'espace laissé entre elles après assemblage est très petit, les fils 13 de connexion entre les lignes 14 et 15 et les lignes 14′ et 15′ sont très courts.

Selon une réalisation particulière de l'invention, la couche de scellement 60 est de l'alliage InPb, qui permet le scellement à une température de l'ordre de 250°. Il en résulte que le boîtier peut ensuite supporter des températures de fonctionnement de -40°C à + 125°C.

Pour rendre étanche la fixation par vis, comme il est requis dans la fabrication des boîtiers hyperfréquences, la tête de vis peut être enrobée d'une résine d'une manière jointive avec le fond du socle 1′.

Pour atteindre de très hautes performances en hyperfréquence, ce boîtier doit constituer un blindage, il est alors préférable qu'il soit réalisé de manière entièrement métallique. Cependant un boîtier métallique étant très coûteux, il peut, pour une réalisation moins onéreuse, être réalisé en plastique métallisé.

Comme il a été dit précédemment, outre les connecteurs périphériques hyperfréquences de type coaxial et d'impédance déterminée, le boîtier selon l'invention présente aussi des connecteurs périphériques de type coaxial pour amener au circuit intégré des tensions d'alimentation continues et le dispositif de connexion présente un nombre correspondant de rubans conducteurs disposés à sa surface pour relier les plots 30 d'alimentation continue du circuit intégré 50 aux connecteurs 3 d'alimentation continue du boîtier.

Dans une réalisation préférentielle, ces connecteurs pour alimentation continue sont disposés à la périphérie du boîtier dans des régions éloignées des connecteurs hyperfréquences. Par exemple, si le boîtier est rectangulaire les connecteurs hyperfréquences peuvent être disposés sur des côtés parallèles et les connecteurs pour tension continue sur les autres côtés parallèles. Dans ces condition les alimentations continues ne perturbent pas les signaux hyperfréquences qui sont souvent d'amplitudes notablement moins fortes.

Les figures 2a et 2b montrent vu du dessus que les parties 5 et 5′ sont disposées de part et d'autre du circuit intégré 50 à une très faible distance des bords de ce circuit permettant de raccorder les lignes hyperfréquences 15, 15′ avec les plots 20 du circuit intégré au moyen de fils très fins de longueur minimale. Ces figures montrent aussi que les parties 4 et 5, et 4′ et 5′ sont très rapprochées de manière à relier les lignes 14, 15 et 14′, 15′ entre elles par des fils fins très courts.

Les plots d'alimentation continue du circuit intégré sont reliés au connecteur en continu 3 au moyen des conducteurs 16 et 17. Entre les conducteurs 16 disposés sur les parties 5 et 5′ du dispositif de connexion situées sur la partie centrale du socle et les conducteurs 17 disposés sur les parties 6 et 6′ du dispositif de connexion situées sur la partie périphérique du socle peuvent être réservées deux bandes métalliques ou métallisés 7 et 7′ pour permettre la disposition de capacités de découplage 8 . Ces bandes 7 et 7′ sont portées par la partie 1′ du socle. D'une façon préférentielle, les capacités de découplage 8 sont formées d'une première armature plane, d'une couche diélectrique, et d'une seconde armature plane, la première armature plane ‘peut être scellée sur l'une des parties métalliques 7 ou 7′, la seconde armature plane étant alors reliée par un fil court et fin d'une part à la ligne conductrice 16 et d'autre part à la ligne conductrice 17.

D'autre part, les connecteurs 2 et 3 sont formés de préférence par une perle de verre scellée dans un orifice périphérique du socle 1′ et munie d'une âme servant de conducteur central de sorte que tous les connecteurs 2 ou 3 sont des connecteurs coaxiaux.

Le boîtier métallique ou métallisé sert alors de masse au conducteur coaxial et l'âme du conducteur coaxial doit être reliée au ruban de la partie supérieure du dispositif de connexion. A cet effet, l'âme du conducteur coaxial est amenée en coïncidence avec les conducteurs soit 14, pour les connecteurs 2, soit 17 pour les connecteurs 3, et s'appuie sur lesdits conducteurs.

Enfin pour rendre ce boîtier étanche, le socle peut être muni d'un couvercle. Tel que représenté sur la figure 2a vue de dessus, un évidement 18 est prévu en surface du socle pour permettre la mise en place du couvercle. D'autre part des vis 19 peuvent servir à la fixation du couvercle sur le socle. Dans une autre forme de réalisation, le couvercle peut être fixé dans l'évidement 18 au moyen de tous produits de scellement connu de l'homme du métier.

Ainsi réalisé le boîtier selon l'invention constitue pour le circuit intégré hyperfréquence un blindage étanche capable de résister aux températures de -40 à + 125° permettant d'amener ou de sortir le nombre de signaux hyperfréquences voulu avec les impédances voulues ; et d'amener également les tensions d'alimentation continues nécessaires au fonctionnement du circuit. La figure 2b montre vue de dessus une variante du socle du boîtier selon l'invention, dans laquelle on trouve 4 connecteurs hyperfréquences au lieu des 2 connecteurs hyperfréquences montrés par la figure 2a. Les lignes hyperfréquences sont alors disposées de manière à éviter entre elles les couplages parasites.

Il est rare que dans un circuit hyperfréquence les entrées/sorties hyperfréquences nécessaires soient plus nombreuses que 4, elles sont en général de 1 à 3. C'est pourquoi, dans une réalisation préférée, le boîtier selon l'invention qui présente par exemple 4 entrées hyperfréquences et 8 connecteurs pour tensions d'alimentation continues permet de couvrir la gamme de la plupart des circuits hyperfréquences actuellement connus.

Dans une réalisation préférentielle le substrat 4, 4′, 5, 5′ est un alumine $Al_2O_3$ d'épaisseur 254μm et les lignes 14, 14′, 15, 15′ présentent une dimension transverse également de 254μm. Le plan de masse 12 du substrat est en or (Au), et les socles du boîtier sont en cuivre, ou bien en laiton, ou encore en aluminium. Ce substrat est scellé sur les blocs 1′ et 1″ au moyen de l'alliage InPb ou tout autre alliage présentant les propriétés requises. La longueur des lignes 14, 15 et 14′, 15′ est de 10 mm et la longueur des lignes 16 et 17 est de 8,5 mm. Pour fonctionner à des fréquences plus élevées on peut utiliser un substrat en alumine d'épaisseur moitié.

On notera que la réalisation de ladite première région du substrat en plusieurs parties 4, 4′ et 6, 6′ permet d'une part l'assemblage des deux parties du socle comme il a été dit, et permet d'autre part l'insertion des capacités 8 de découplage en continu. Cette réalisation permet aussi de réaliser le nombre de lignes hyperfréquences ou continues adaptées au circuit à protéger, sans incidence sur les deux parties 1′ et 1″ du socle du boîtier.

La seconde région du substrat, subdivisée en parties 5 et 5′ pour s'adapter à peu de frais au circuit intégré à protéger, peut comprendre le remplacement d'un tronçon de lignes hyperfréquences 15, par un circuit d'accord (non représenté) qui permet de compenser les pertes dues aux petits fils 13 pour les fréquences supérieures à 60 GHz.

De plus, il peut être prévu de réaliser, entre les lignes hyperfréquences adjacentes, telles que 15a, 15b ou 15c, 15d, dans le cas où le dispositif de connexion comporte plus de 2 lignes hyperfréquences (voir figure 2b), une petite fente 70 dans le substrat 5, 5′, entre les extrémités desdites lignes proches du circuit intégré, pour diminuer les couplages parasites. La dimension de la fente perpendiculairement au circuit intégré doit être inférieure au quart de la longueur d'onde associée à la fréquence du signal.

Les lignes microrubans, et continues, et éventuellement les circuits d'accord sont réalisés par toutes techniques connues de l'homme du métier compatibles avec le substrat du dispositif de connexion. Par exemple, par une technologie de couches minces si le substrat est semi-isolant ou semiconducteur, et par une technologie de couches dites épaisses sérigraphiées si le substrat est en céramique.

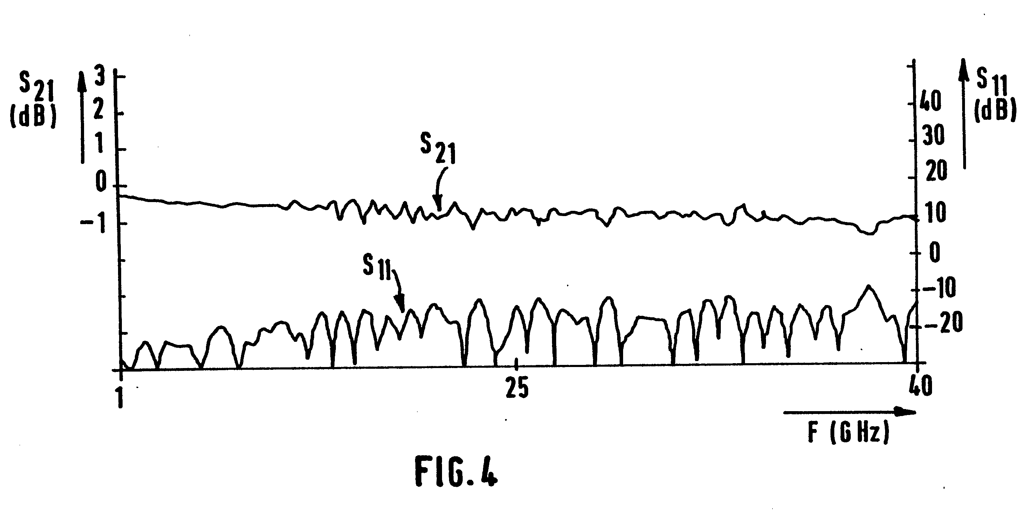

La figure 4 représente les coefficients $S_{11}$ et $S_{21}$ d'un dispositif hyperfréquences formé d'un boîtier selon l'invention muni d'un circuit intégré en place. La courbe $S_{21}$ représente, à l'échelle 1dB par unité, en fonction de la fréquence en GHz, le coefficient de transmission de ce dispositif d'un connecteur à un autre connecteur, toutes les impédances caractéristiques des lignes et connecteurs hyperfréquences étant de 50 Ω. La courbe $S_{11}$ représente à l'échelle 10 dB par unité, en fonction de la fréquence en GHz le coefficient de réflexion du même système.

L'expérimentation montre que le boîtier selon l'invention permet le fonctionnement de circuits intégrés à des fréquences supérieures à 40 GHz et même jusqu'à 60 GHz. L'expérimentation montre aussi qu'une coupure dans le plan de masse 60, la masse se faisant cependant par l'intermédiaire du socle du boîtier, résulte en une fréquence de coupure de l'ordre de 20 GHz pour le fonctionnement du circuit intégré, et qu'il se produit des résonances et des pertes.

Les petits fils fins 13 peuvent être soudés par thermocompression.

## Revendications

1. Boîtier pour circuit intégré hyperfréquences (50) comprenant un socle (1) muni d'un évidement (10) dont le fond est métallisé et de connecteurs périphériques (2,3), et comprenant un dispositif de connexion inséré dans l'évidement entre le circuit intégré et les connecteurs, ce dispositif de connexion incluant un substrat qui présente une face supérieure munie de lignes microrubans (14,15,16,17) pour relier des plots (20,30) du circuit intégré aux connecteurs (2,3) du socle et une face inférieure métallisée pour former un plan de masse (12), caractérisé en ce que le socle comprend deux parties assemblées, la première partie (1') dite périphérique portant les connecteurs (2,3), une première région du dispositif de connexion (4,4',6,6') et un logement (11) pratiqué dans l'évidement (10), logement (11) dont les dimensions sont indépendantes de celles du circuit intégré (50) à protéger, et qui est approprié à recevoir au plus juste la seconde partie (1") dite centrale, cette dernière portant le circuit intégré (50) et une seconde région (5,5') du dispositif de connexion dite complémentaire, dont les dimensions sont dépendantes de celles du circuit intégré (50) à protéger, pour approcher ce dernier au plus près, de manière telle que la longueur des fils de connexion (13) entre les lignes microrubans (15,16) et les plots (20,30) du circuit intégré est minimale.

2. Boîtier selon la revendication 1, caractérisé en ce que la première et la seconde partie (1,1") du socle (1) comprennent des moyens d'assemblage pour reconstituer un plan de masse (12) continu sous l'ensemble des première (4,4') et seconde (5,5') régions du dispositif de connexion, de manière à éviter la formation de discontinuité constituant des cavités résonnantes en hyperfréquences.

3. Boîtier selon la revendication 2, caractérisé en ce que les moyens d'assemblage incluent :
- d'une part la disposition de la première région (4,4')du dispositif de connexion en retrait par rapport au bord du logement (11), ainsi qu'une couche métallique (60) interposée entre le plan de masse (12) de cette première région et le fond de l'évidement (10) métallisé, cette couche métallique (60) étant en biseau entre le bord de la première région (4,4') et le bord du logement ;
- d'autre part la disposition de la région (5,5') complémentaire du dispositif de connexion en surplomb par rapport au bord de la partie centrale (1") du socle, ce surplomb étant d'une grandeur sensiblement égale à la dimension du retrait de la première partie (4,4'), ainsi qu'une couche métallique (60) de même épaisseur que précédemment, interposée entre le plan de masse (12) de la région dite complémentaire du dispositif de connexion et le fond de l'évidement (10) métallisé, cette couche métallique (60) étant en biseau entre le bord de ladite région complémentaire (5,5') et le bord de ladite partie centrale (1") du socle ;
en ce que ces moyens incluent encore le fait que ces couches métalliques ainsi interposées constituent un scellement desdites régions du dispositif de connexion (4,4',5,5') sur leur partie du socle respective dans lesdites positions, et en ce que ces moyens incluent aussi le contact des deux parties (1',1") du socle par les surfaces disposées l'une sur l'autre des plages biselées de pente complémentaire desdites couches métalliques (60), ainsi que l'assujettissement des deux parties du socle entre elles pour maintenir la continuité du plan de masse formé par lesdites couches métalliques.

4. Boîtier selon la revendication 3, caractérisé en ce que l'assujetissement des deux parties (1' ,1") du socle est fait par au moins une vis (52) unissant le fond du logement (11) pratiqué dans la première partie (1') du socle, à la partie centrale (1") du socle disposée dans ce logement (11).

5. Boîtier selon la revendication 4, caractérisé en ce que la tête de vis (52) est enrobée d'une résine jointive avec le fond du socle (1').

6. Boîtier selon l'une des revendications 4 ou 5, caractérisé en ce que il est métallique.

7. Boîtier selon l'une des revendications 4 ou 5, caractérisé en ce qu'il est formé d'un matériau plastique métallisé.

8. Boîtier selon l'une des revendications 6 ou 7, caractérisé en ce que le substrat du dispositif de connexion (4,4',5,5',6,6') est en alumine (Al₂O₃) dont la face inférieure porte un plan de masse (12), par exemple réalisé au moyen d'une couche d'or, et en ce que la couche métallique (60) qui est interposée entre les parties du dispositif de connexion et leurs parties de socle respectives est une couche d'alliage InPb qui effectue aussi le scellement entre les parties respectives et assure la continuité du plan de masse (12) par le contact de ses plages biselées de pente complémentaire.

9. Boîtier selon l'une des revendications 6 à 8, caractérisé en ce que les connecteurs périphériques (2,3) comprennent au moins un connecteur hyperfréquences (2) de type coaxial et d'impédance déterminée, et en ce que le dispositif de connexion comprend au moins une ligne microruban (14,15) de même impédance, joignant un plot du circuit intégré audit connecteur.

10. Boîtier selon la revendication 9, caractérisé en ce que, pour obtenir des lignes hyperfréquences d'impédances déterminées, le substrat du dispositif de connexion présente une épaisseur fonction de la largeur de la ligne microruban et de la fréquence de fonctionnement du circuit intégré, la ligne hyperfréquence étant constituée des trois couches superposées du plan de masse (12), du matériau du substrat (4,4' ,5,5') et du ruban métallique (14,15) disposées en surface de ce substrat.

11. Boîtier selon la revendication 10, caractérisé en ce qu'il comprend un ou plusieurs connecteurs (2) coaxiaux hyperfréquences d'impédances 50Ω, et un nombre correspondant de lignes microruban (14,15) de même impédance, pour relier des plots (20) du circuit intégré auxdits connecteurs, les lignes hyperfréquences étant en outre disposées les unes par rapport aux autres de manière à éviter les couplages parasites.

12. Boîtier selon l'une des revendications 9 à 11 caractérisé en ce qu'il comprend un ou plusieurs connecteurs (3) et un nombre correspondant de rubans conducteurs (16,17) en surface du dispositif de connexion (5,5´,6,6´) pour relier des plots (30) du circuit intégré à des alimentations continues.

13. Boîtier selon la revendication 12, caractérisé en ce que ces connecteurs (3) pour alimentation continue sont du type coaxial et sont disposés à la périphérie du boîtier dans des régions éloignées des connecteurs hyperfréquences (2).

14. Boîtier selon la revendication 13, caractérisé en ce qu'il est de forme quadrangulaire, les connecteurs hyperfréquences (2) étant sur des côtés parallèles, les connecteurs continus (3) sur les autres côtés parallèles.

15. Boîtier selon l'une des revendications 12 à 14, caractérisé en ce qu'une capacité (8) est disposée entre deux tronçons (16,17) de rubans conducteurs pour former une ligne d'alimentation continue découplée du circuit intégré.

16. Boîtier selon l'une des revendications 9 à 15, caractérisé en ce que les connecteurs coaxiaux (2,3) sont constitués par une âme (2´,3´) isolée du boîtier métallique (1) ou métallisé par une perle de verre scellée au boîtier (1), par exemple par un alliage InPb.

17. Boîtier selon l'une des revendications 15 ou 16 caractérisé en ce que les capacités de découplage (8) sont formées de la succession d'une première couche métallique, d'une couche diélectrique, et d'une seconde couche métallique, la première couche métallique étant fixée sur le boîtier (1) métallique ou métallisé formant masse, et la seconde couche métallique étant reliée par des fils (13) courts et fins aux extrémités les plus proches des tronçons de lignes conductrices (16,17) pour alimentations continues.

18. Boîtier selon l'une des revendications 1 à 17 caractérisé en ce que la partie centrale (1´´) du socle portant le circuit intégré à sa surface et munie d'un MESA (51) pour recevoir ce circuit intégré de dimension transversale identique à celle du circuit intégré, de manière telle que la surface supérieure du circuit intégré (50) est au même niveau que la surface supérieure du dispositif de connexion (5,5´), pour permettre la liaison entre les extrémités des lignes microrubans ou des conducteurs au moyen de fils fins (13) extrêmement courts.

19. Boîtier selon l'une des revendications précédentes, caractérisé en ce que ladite seconde région (5,5´) du dispositif de connexion comporte un circuit d'accord disposé entre deux tronçons d'une ligne hyperfréquences (15).

20. Boîtier selon l'une des revendications précédentes dans la mesure où elle dépend de la revendication 9, caractérisé en ce que le dispositif de connexion (5,5´) comprend au moins deux lignes hyperfréquences (15a, 15b) dont les extrémités les plus proches du circuit intégré sont séparées par une petite fente (70) pratiquée dans le substrat du dispositif de connexion pour éviter les couplages parasites entre les signaux transportés par les deux lignes.

21. Boîtier selon l'une des revendications 1 à 20, caractérisé en ce qu'il est muni d'un couvercle fixé au socle de façon étanche.

FIG.1a

EP 0 387 955 A1

FIG.1b

FIG.2a

FIG.2b

EP 0 387 955 A1

EP 0 387 955 A1

**FIG.3**

5-Ⅵ-PHF 89-521

FIG.4

EP 0 387 955 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-157505 (FUJITSU)<br>* page 3, ligne 28 - page 4, ligne 10; figure 3 * | 1, 2, 6, 21 | H01L23/66 |
| A | EP-A-1890 (THE SECRETARY OF STATE FOR DEFENCE-UNITED KINGDOM)<br>* page 3, lignes 7 - 10; figures 1, 2 * | 1, 2, 8, 9, 18, 20 | |
| A | EP-A-144071 (FUJITSU)<br>* page 4, lignes 27 - 28 *<br>* page 4, ligne 31 - page 5, ligne 13; figure 2 * | 1, 6, 9 | |
| A | US-A-3869677 (E.F. BELOHOUBEK)<br>* abrégé *<br>* colonne 2, ligne 3 - colonne 4, ligne 12; figures 1, 2 * | 1, 2 | |
| A | US-A-3786375 (H. SATO)<br>* abrégé *<br>* colonne 3, lignes 7 - 10; revendications 1, 2, 5; figures 2A, 2B * | 1, 2 | |

**DOMAINES TECHNIQUES RECHERCHES (Int. Cl.5)**

H01L

Le présent rapport a été établi pour toutes les revendications

| Lieu de la recherche | Date d'achèvement de la recherche | Examinateur |
|---|---|---|
| LA HAYE | 25 JUIN 1990 | DELPORTE B.P.M. |